(19) Europäisches Patentamt / European Patent Office / Office européen des brevets

(11) **EP 3 526 619 B1**

(12) **FASCICULE DE BREVET EUROPEEN**

(45) Date de publication et mention de la délivrance du brevet:
**05.04.2023 Bulletin 2023/14**

(21) Numéro de dépôt: **17794008.7**

(22) Date de dépôt: **16.10.2017**

(51) Classification Internationale des Brevets (IPC):
*G01R 31/36* (2006.01)    *H01M 10/48* (2006.01)

(52) Classification Coopérative des Brevets (CPC):
**H01M 10/482; G01R 31/396;** G01R 31/3648;
Y02E 60/10

(86) Numéro de dépôt international:
**PCT/FR2017/052833**

(87) Numéro de publication internationale:
**WO 2018/073519 (26.04.2018 Gazette 2018/17)**

(54) **DISPOSITIF D'INTERFACE ENTRE UN SYSTEME DE GESTION DE BATTERIES ET DES GROUPES DE CELLULES**

VORRICHTUNG ZUR SCHNITTSTELLENBILDUNG ZWISCHEN EINEM BATTERIEVERWALTUNGSSYSTEM UND GRUPPEN VON ZELLEN

DEVICE FOR INTERFACING BETWEEN A BATTERY MANAGEMENT SYSTEM AND GROUPS OF CELLS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.10.2016 FR 1660056**

(43) Date de publication de la demande:
**21.08.2019 Bulletin 2019/34**

(73) Titulaire: **Faiveley Transport Tours**
**37700 Saint Pierre des Corps (FR)**

(72) Inventeurs:
• **AUBIN, Philippe**
**37390 Chanceaux sur Choisille (FR)**
• **COLAS, Bruno**
**37300 Joue les Tours (FR)**

(74) Mandataire: **Santarelli**
**49, avenue des Champs-Elysées**
**75008 Paris (FR)**

(56) Documents cités:
| | |
|---|---|
| EP-A1- 2 273 680 | EP-A1- 2 485 293 |
| EP-A2- 1 006 597 | DE-A1-102007 050 821 |
| JP-A- 2011 247 760 | US-A1- 2008 233 471 |
| US-A1- 2009 085 681 | US-A1- 2011 140 665 |
| US-A1- 2011 316 483 | US-A1- 2013 065 093 |
| US-A1- 2014 132 218 | US-A1- 2016 126 892 |

**Description**

La présente invention concerne un dispositif d'interface entre un système de gestion de batteries et des groupes de cellules d'un module de batteries.

L'invention concerne également un système de gestion de batteries comportant un tel dispositif d'interface, et un module de batteries comportant un tel dispositif d'interface.

Elle concerne également un ensemble formé de groupes de cellules de batterie, un système de gestion de batteries et un dispositif d'interface entre les groupes de cellules de batterie et le système de gestion de batteries.

Un module de batteries est formé par un ensemble d'accumulateurs électriques, cellules de batterie ou éléments de batterie.

En général, dans un module de batteries, plusieurs cellules de batterie sont connectées en parallèle entre elles formant un bloc ou groupe de cellules. Plusieurs blocs de cellules sont connectés en série entre eux afin de former une colonne de blocs de cellules ou colonne de cellules. Un module de batteries comporte plusieurs colonnes de cellules reliées en parallèle entre elles.

Des circuits électroniques sont associés aux modules de batterie afin d'assurer le bon fonctionnement des modules de batteries. En particulier, ces circuits électroniques surveillent la valeur des paramètres relatifs aux cellules de batterie.

Par exemple, le document EP 1 977 263 décrit un circuit électronique vérifiant que la tension d'une cellule de batteries ne dépasse pas une tension de seuil. Un circuit électronique est ainsi associé à chaque cellule de batterie d'un module de batterie et compare la tension de la cellule à une tension de seuil. Lorsqu'une cellule de batterie dépasse la tension de seuil, le processus de charge du module de batterie est arrêté.

Dans un tel système, la tension de seuil est fixée par le circuit électronique et une seule opération est prévue lors du dépassement d'une des cellules de la tension de seuil, le système n'étant ainsi pas flexible.

Il existe des circuits électroniques plus évolués assurant le bon fonctionnement des modules de batteries, tels que des systèmes de contrôle de batteries, connus en nomenclature anglo-saxonne comme « *Batterie Management System* » ou BMS.

Les systèmes de contrôle de batteries sont largement utilisés aujourd'hui et sont indispensables pour des modules de batterie utilisant certaines technologies, telle que la technologie Lithium-Ion.

Entre autres, les systèmes de contrôle de batteries surveillent certains paramètres relatifs aux cellules de batterie ou éléments de batterie, tels que la tension ou la température, assurant qu'ils restent dans une plage de valeurs prédéterminée.

Ainsi, les systèmes de contrôle de batteries surveillent et contrôlent le fonctionnement des cellules de batterie et identifient par exemple celles dans lesquelles une valeur de tension et/ou de température peut présenter un problème dans le fonctionnement du module de batteries.

De plus, à partir de ces mesures de tension, les systèmes de contrôle de batteries cherchent à rendre homogène les tensions des cellules. Pour cela ils déchargent les cellules dont la tension est trop élevée par rapport à une valeur de seuil, en connectant par exemple une résistance de décharge en parallèle de ces cellules. Ce procédé est généralement connu sous le nom d'équilibrage.

Une architecture de système de contrôle de batteries connue comporte des blocs électroniques locaux, un bloc électronique local étant associé à un ou plusieurs blocs de cellules, et un bloc électronique global associé à chaque colonne de cellules et étant relié aux blocs électroniques locaux associés à un ou plusieurs blocs de cellules dans la colonne.

Dans un système de contrôle de batteries ayant une telle structure, chaque bloc électronique local réalise des mesures de tension et/ou de température des blocs de cellules qui lui sont associés, les valeurs de tension et de température mesurées étant envoyées au bloc électronique global associé à la colonne de cellules.

Le bloc électronique global associé à une colonne de cellules reçoit ainsi les valeurs de tension et/ou de température mesurées pour les blocs de cellules de la colonne de cellules et contrôle le fonctionnement des blocs de cellules à partir des valeurs reçues.

Ainsi, par exemple, le bloc électronique global peut identifier un bloc de cellules dépassant une valeur de tension ou de température maximale ou minimale ou commander une opération d'équilibrage dans un bloc de cellules particulier.

Le système de contrôle de batteries peut être utilisé de manière flexible, c'est-à-dire par exemple, les valeurs de tension et de température maximales et minimales peuvent être modifiées et les stratégies de gestion des cellules utilisant les valeurs mesurées dans les cellules peuvent être variées.

Pour des modules de batteries dans lesquels les blocs de cellules comportent très peu de cellules (par exemple 1 à 3 cellules) et qui nécessitent des redondances des mesures de tensions de chaque bloc de cellules, les systèmes de contrôle de batteries sont ainsi des systèmes complexes et utilisent un grand nombre de circuits intégrés spécialisés.

Il est connu du document EP 2 485 293 A1, un dispositif d'interface entre un système de gestion de groupes de cellules de batterie comportant un ensemble d'unités locales et au moins une unité globale reliée aux unités locales et comportant des moyens de connexion au système de gestion de batteries. Chaque unité locale de l'ensemble est configurée pour être associée à un groupe de cellules de batterie. Dans ce système, l'unité globale et les unités locales sont connectées en série dans une boucle afin qu'un signal soit transmis à l'unité globale dès qu'une anomalie est détectée au niveau d'une des unités locales.

Le document JP 2011 247760 A décrit un dispositif d'interface entre un système de gestion de batteries et des groupes de cellules de batterie comportant un ensemble d'unités locales et au moins une unité globale. L'unité globale se présente sous la forme d'une fonction OU dont les entrées sont reliées aux unités locales et la sortie est reliée au système de gestion de batteries.

Ainsi, l'utilisation d'un nombre élevé de circuits intégrés spécialisés dégrade la fiabilité du système et implique un coût élevé dans la mise en oeuvre d'un module de batteries, en particulier pour des modules de batteries avec un nombre élevé de cellules de batterie.

La présente invention a pour but de proposer un dispositif d'interface entre un système de gestion de batterie et des groupes de cellules de batterie d'un module de batteries simplifiant la gestion des groupes de cellules tout en augmentant la fiabilité de la gestion.

A cet effet, l'invention propose un dispositif d'interface selon la revendication indépendante 1. Des modes de réalisation particuliers de l'invention sont définis selon les revendications dépendantes.

D'autres particularités et avantages de l'invention apparaîtront encore dans la description ci-après.

Aux dessins annexés, donnés à titre d'exemple non limitatif :

- la figure 1 représente schématiquement une architecture de module de batteries ;
- la figure 2 illustre schématiquement un ensemble formé par le module de batteries de la figure 1, un système de gestion de batteries et un dispositif d'interface selon un mode de réalisation ;
- la figure 3 illustre des schémas de circuits électroniques dans une unité locale conforme à un mode de réalisation ;
- la figure 4 illustre des schémas de circuits électroniques dans une unité globale selon un mode de réalisation ;
- la figure 5 représente des circuits électroniques dans une unité locale selon un mode de réalisation ; et
- la figure 6 illustre des schémas de circuits électroniques dans une unité globale selon un mode de réalisation.

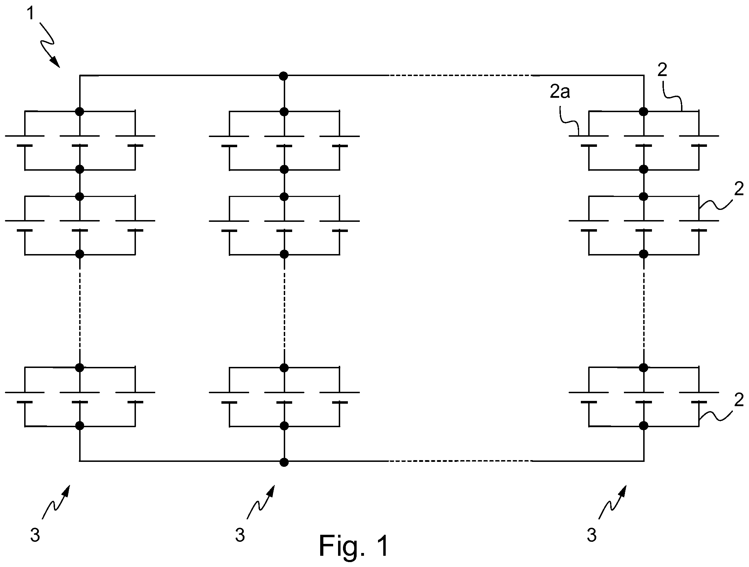

La **figure** 1 représente un module de batteries pour lesquelles s'applique l'invention.

Dans l'architecture représentée, le module de batteries 1 comporte des groupes de cellules 2 connectées en série entre eux, de sorte à former une colonne de groupes de cellules ou colonne de cellules 3. Chaque groupe de cellules de batterie 2 comporte plusieurs cellules de batterie 2a connectées en parallèle entre elles.

Le module de batterie 1 représenté comporte plusieurs colonnes de cellules 3 reliées en parallèle entre elles.

Dans un mode de réalisation, chaque groupe de cellules 2 comporte trois cellules de batterie 2a connectées en parallèle entre elles. Bien entendu, le nombre de cellules de batterie par groupe de cellules 2 pourrait être différent à trois, et même pourrait comporter une unique cellule de batterie.

Dans le mode de réalisation représenté, trois groupes de batteries 2 sont représentés par colonne et trois colonnes 3 sont représentées dans le module de batterie 1.

Bien entendu, le nombre de groupes de cellules 2 par colonne de cellules 3 et le nombre de colonnes 3 par module de batteries 1 est variable.

Différents types de batteries peuvent être utilisés dans les modules de batteries selon l'architecture décrite, par exemple des batteries du type Lithium-Ion. L'utilisation de ce type de cellules de batterie permet de mettre en oeuvre des modules de batteries ayant un volume et un poids réduits pour une capacité équivalente à un module de batteries utilisant d'autres types de batteries.

Ces types de modules de batteries peuvent avoir des applications diverses et peuvent s'appliquer particulièrement aux véhicules de transport tels que des véhicules de transport ferroviaires, comme par exemple les trains, les métros, les tramways, les trolley-bus, etc.

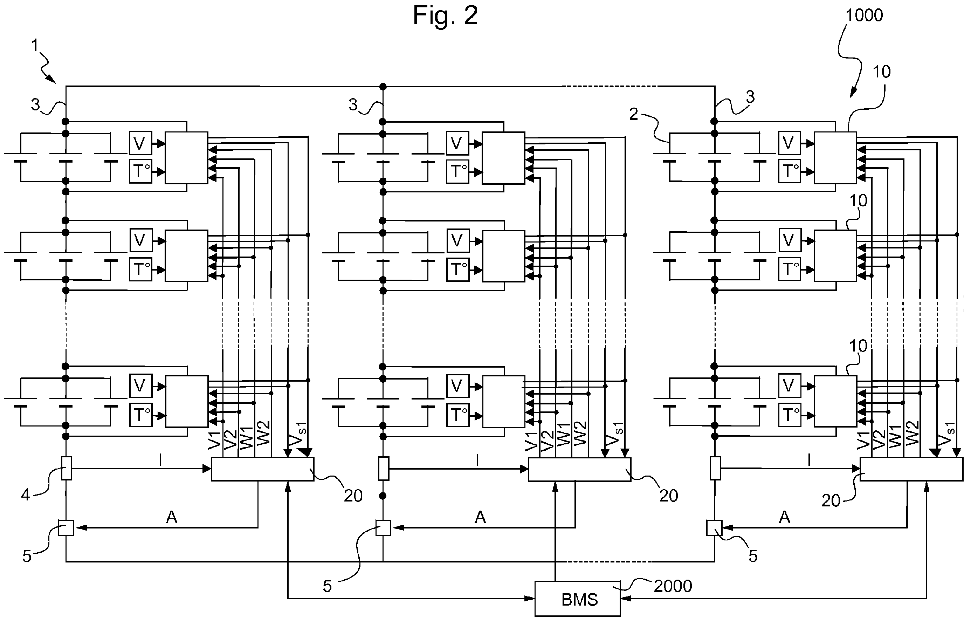

Sur la **figure 2,** un dispositif d'interface 1000 entre un système de gestion de batteries 2000 et le module de batteries décrit en référence à la figure 1 est illustré.

Le dispositif d'interface 1000 comporte plusieurs ensembles d'unités locales 10 et plusieurs unités globales 20. Un ensemble d'unités locales 10 est formé dans ce mode de réalisation par les unités locales 10 associées à des groupes de cellules de batterie 2 reliées en série, c'est-à-dire faisant partie d'une même colonne de batteries 3. Dans ce mode de réalisation, les unités locales 10 d'un ensemble d'unités locales sont reliées à une unité globale 20.

Ainsi, un ensemble d'unités locales peut être défini comme plusieurs unités locales 10 reliées à une même unité globale 20.

L'unité globale 20 comporte des moyens de connexion (non représentés sur la figure) à un système de gestion de batteries 2000.

On notera ainsi que le dispositif d'interface 1000 met en oeuvre une interface entre le module de batteries 1 et un système de gestion de batteries 2000.

Sur la figure 2, trois unités globales 20 sont représentées, chaque unité globale 20 étant reliée à plusieurs unités locales 10 formant un ensemble d'unités locales.

Sur la figure, seulement trois ensembles d'unités locales reliées à trois unités globales respectivement sont illustrées.

On notera que dans le mode de réalisation illustré, chaque ensemble d'unités locales et l'unité globale à laquelle l'ensemble d'unités locales 10 est relié sont associés à une colonne de cellules 3.

Selon d'autres modes de réalisation, plusieurs ensembles d'unités locales et une unité globale associée peuvent être associés à des groupes de cellules de batterie faisant partie d'une même colonne de batteries.

Selon d'autres modes de réalisation, une unique unité globale peut être reliée aux unités locales associées à des groupes de cellules de batterie faisant parties des colonnes des cellules différentes.

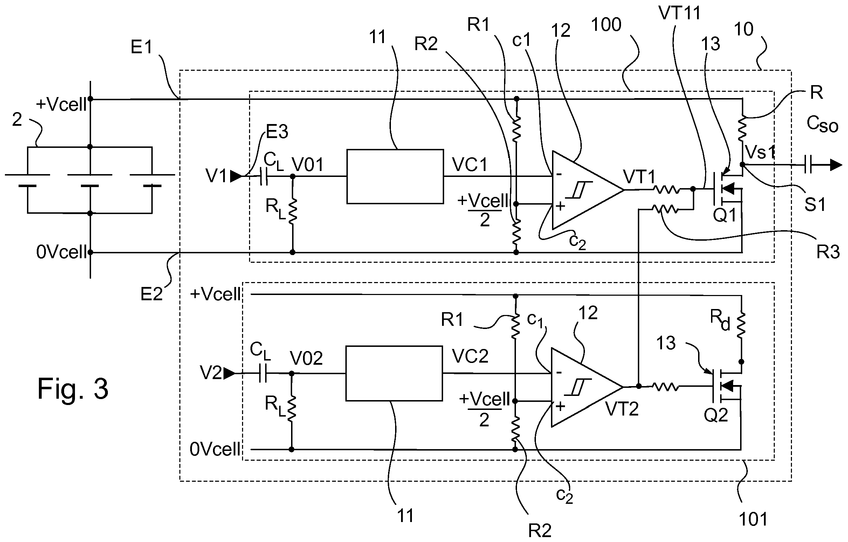

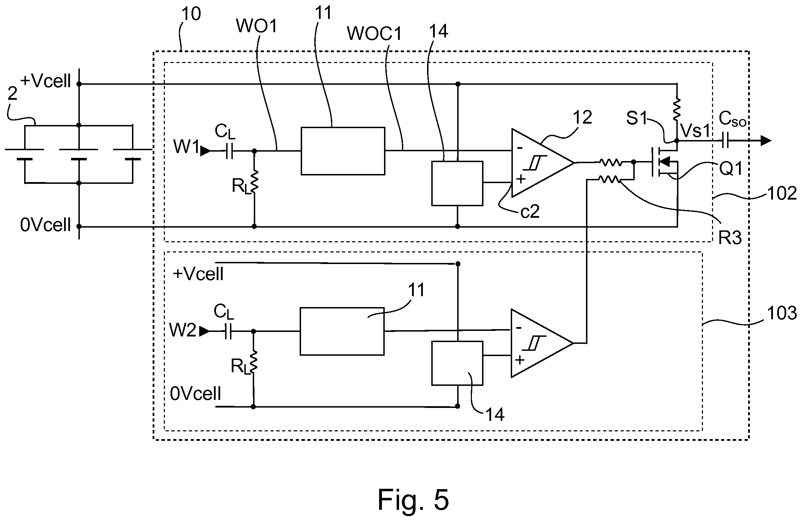

Une unité locale 10 est configurée pour comparer un paramètre relatif à un groupe de cellules associées 2 avec une valeur de consigne. Les moyens pour mettre en oeuvre cette comparaison seront décrits ultérieurement en référence aux figures 3 et 5.

La valeur de consigne utilisée par les unités locales 10 provient de l'unité globale 20 à laquelle l'unité locale 10 est reliée.

Chaque unité locale 10 est en outre configurée pour générer un signal de sortie Vs1 représentatif du résultat de la comparaison. Le signal de sortie Vs1 est adressé à l'unité globale 20.

L'unité globale 20 est configurée pour recevoir la valeur de consigne. Par exemple la valeur de consigne provient d'un système de gestion de batteries 2000.

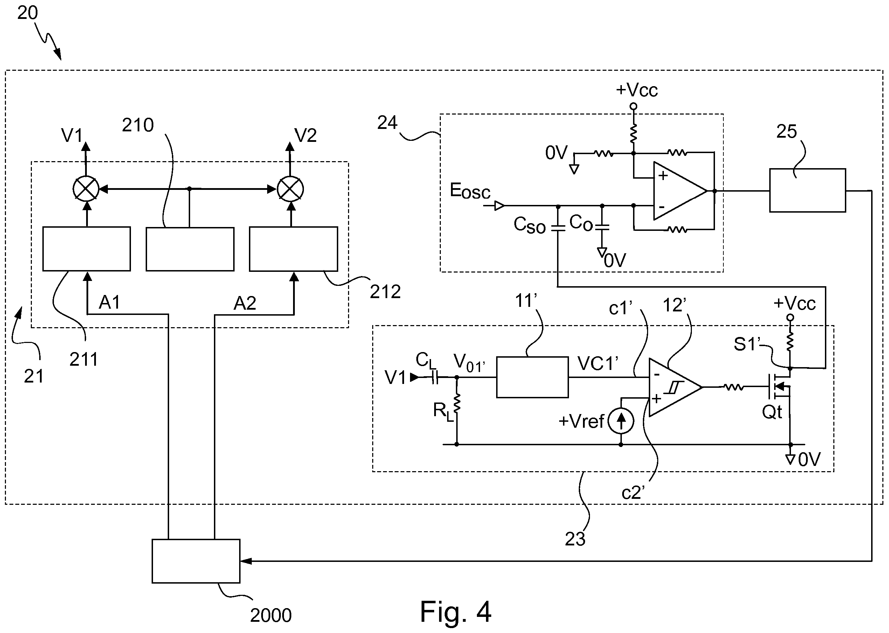

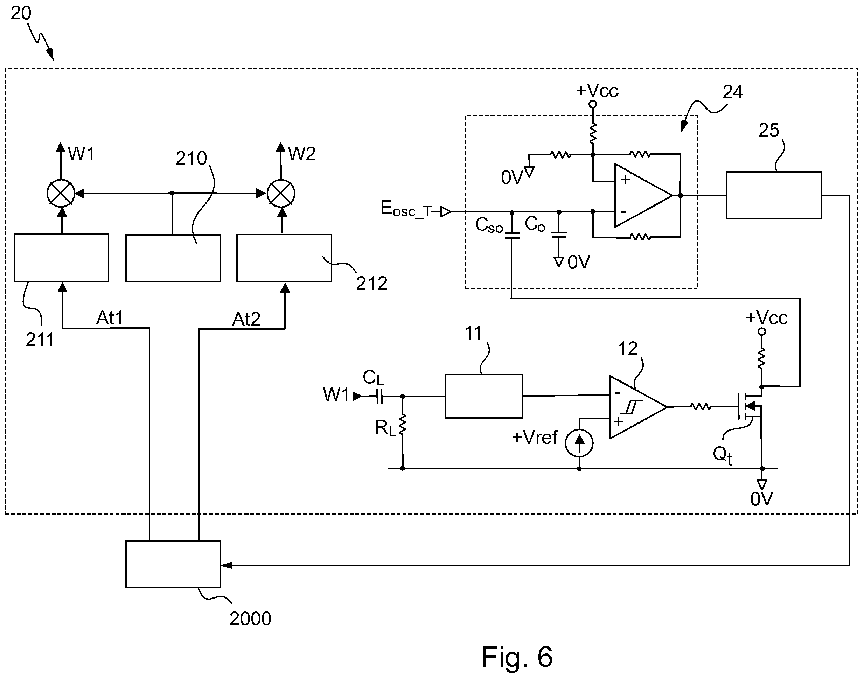

L'unité globale 20 comporte un module électronique (24, illustré aux figures 4 et 6) ayant un paramètre de fonctionnement présentant une valeur globale qui est fonction des signaux de sortie Vs1 provenant des unités locales 10 de l'ensemble d'unités locales associées à l'unité globale 20.

Le signal de sortie Vs1 représentatif du résultat de la comparaison peut ainsi, soit indiquer que la valeur du paramètre relatif à un groupe de cellules associés est supérieure à la valeur de consigne, soit que la valeur du paramètre est inférieure à la valeur de consigne.

La valeur globale du paramètre de fonctionnement du module électronique est représentative du nombre de résultats de comparaison indiquant que la valeur du paramètre est supérieure à la valeur de consigne ou du nombre de résultats de comparaison indiquant que la valeur du paramètre est inférieure à la valeur de consigne.

Comme il sera décrit ultérieurement, les signaux de sortie Vs1 provenant des unités locales 10 agissent sur la valeur globale du paramètre de fonctionnement du module électronique.

Autrement dit, le module électronique de l'unité globale 20 reçoit les signaux de sortie Vs1 des unités locales 10, la valeur globale du paramètre du fonctionnement étant modifiée par les signaux de sortie Vs1 provenant des unités locales 10.

L'unité globale 20 est configurée en outre pour transmettre la valeur globale du paramètre du fonctionnement du module électronique de l'unité globale 20 à un système de gestion de batteries 2000.

Lorsque le dispositif d'interface 1000 est installé entre un module de batteries 1 et un système de gestion de batteries 2000, le système de gestion de batteries 2000 génère la valeur de consigne et l'adresse à l'unité globale 20, l'unité globale 20 l'adressant à son tour aux unités locales 10 de l'ensemble d'unités locales 10 associées.

Le système de gestion de batteries 2000 peut aussi recevoir de la part du dispositif d'interface 1000 la valeur globale du paramètre de fonctionnement du module électronique de l'unité globale 20.

Grâce à cette valeur globale, le système de gestion de batteries 2000 peut calculer le nombre de résultats positifs des comparaisons et du nombre des résultats négatifs. Le système de gestion de batteries peut ainsi déduire en fonction de la valeur globale s'il existe des groupes de cellules de batterie dépassant la valeur de consigne pour un paramètre, tels que par exemple la tension ou la température, relative à un groupe de cellules de batterie.

En outre, le système de gestion de batteries 2000 peut par exemple modifier la valeur de consigne, et réaliser par exemple un balayage de valeurs de consigne et d'obtenir des valeurs globales associées à chaque valeur de consigne. Avec ces valeurs globales obtenues respectivement pour les valeurs de consigne, le système de gestion de batteries 2000 peut obtenir par exemple un histogramme représentatif du nombre de cellules dépassant ou étant inférieur à des valeurs de consigne.

Le système de gestion de batteries peut en outre vérifier que le signal de sortie Vs1 d'une unité locale 10 ne reste pas figé dans un état, signe d'une défaillance du dispositif d'interface. Par exemple, il peut être vérifié que lorsque la valeur de consigne varie entre sa valeur minimum et celle maximum, les valeurs globales représentatives du nombre de résultats de comparaison comprennent au moins une valeur représentative d'un nombre nul de résultats de comparaison et celle représentative d'un nombre maximum possible de résultats de comparaison. Par conséquent, le bon fonctionnement du dispositif d'interface 1000 peut être assuré.

La **figure** 3 représente un groupe de cellules de batterie 2 avec une unité locale associée 10.

L'unité locale 10 comporte une première entrée E1 et une deuxième entrée E2 qui sont reliées respectivement aux bornes du groupe de cellules de batterie 2.

Ainsi, l'unité locale 10 reçoit à travers de la première entrée E1 et la deuxième entrée E2 la tension Vcell aux bornes du groupe de cellules de batterie 2.

L'unité locale 10 comporte une troisième entrée E3 au moyen de laquelle elle reçoit un signal V1 représentatif de la valeur de consigne provenant de l'unité globale 20.

Un premier condensateur, nommé condensateur de couplage $C_L$ est connecté entre la troisième entrée E3 et un module détecteur de crête 11. La sortie VC1 du détecteur de crête 11 est reliée à une première entrée c1 d'un comparateur 12. Une résistance de couplage $R_L$ est connectée entre l'entrée du détecteur de crête 11 et la deuxième entrée E2 de l'unité locale 10, cette deuxième entrée E2 de l'unité locale 10 recevant une tension de référence, étant ici de zéro volt (0Vcell sur la figure).

Deux résistances R1, R2 sont connectées en série entre elles et, entre la première entrée E1 et la deuxième entrée E2 de l'unité locale 10 formant un diviseur de tension.

La tension prise entre les deux résistances R1, R2 est reliée à une deuxième entrée c2 du comparateur 12.

Dans le mode de réalisation décrit, les valeurs des résistances R1, R2 du diviseur de tension sont identiques, la tension prise entre les résistances étant ainsi égale à la moitié de la tension Vcell aux bornes du groupe de cellules de batterie 2 (Vcell/2).

Dans le mode de réalisation décrit, le comparateur 12 est un comparateur à hystérésis.

Le comparateur 12 génère en sortie un signal de sortie VT1 représentatif du résultat de la comparaison des signaux en entrée à ces bornes d'entrée c1, c2.

Des moyens de commutation 13 sont reliés à la sortie du comparateur 12. Ainsi, les moyens de commutation 13 sont contrôlés par le signal de sortie VT1 du comparateur 12. En fonction du signal de sortie VT1 du comparateur 12, les moyens de commutation 13 sont activés ou désactivés permettant de modifier le signal de sortie Vs1 de l'unité locale 10, ce signal de sortie Vs1 étant pris à la sortie S1 de l'unité locale 10.

Les moyens de commutation 13 permettent en outre de relier à la sortie S1 de l'unité locale 10 le signal de sortie VT1 du comparateur 12.

Ainsi, en fonction de l'état de fonctionnement des moyens de commutation 13, le signal de sortie Vs1 est différent, le signal de sortie Vs1 étant représentatif du résultat de la comparaison mise en oeuvre par le comparateur 12.

Dans un mode de réalisation, les moyens de commutation sont un transistor à effet de champ Q1 ou MOSFET (pour « *MetalOxyde Semi-conductor Field Effect Transistor »*).

Dans le mode de réalisation décrit le transistor à effet de champ Q1 est de type N.

Un condensateur de sortie Cso est relié à la sortie S1 de l'unité locale 10 par une première borne, sa deuxième borne étant reliée à l'unité globale 20.

Dans d'autres modes de réalisation, la capacité de sortie Cso est inclue dans l'unité globale 20.

En outre, les moyens de comparaison 12 ainsi que les moyens de commutation 13 pourraient être d'autres types que ceux décrits en référence à la figure 3.

De plus, différents types de transistors peuvent être utilisés, étant bien entendu adaptés à fonctionner avec le comparateur qui pourrait être d'un type autre qu'à hystérésis.

Une résistance R est connectée entre le drain du transistor Q1 et la borne positive Vcell du groupe de cellules de batterie 3. Son rôle sera décrit ultérieurement.

Le circuit électronique décrit ci-dessus forme un premier module de comparaison 100, et son fonctionnement sera décrit ci-dessous.

L'unité locale 10 comporte en outre un deuxième module de comparaison 101 similaire au premier module de comparaison 100. La structure du deuxième module de comparaison étant similaire à la structure du premier module de comparaison n'est pas décrite à nouveau.

On notera que dans ce document, des composants identiques, bien qu'ils soient répétés dans des modules différents, portent la même référence numérique.

Le deuxième module de comparaison 101 reçoit en entrée la tension aux bornes du groupe de cellules de batterie 2 ainsi qu'un second signal de consigne V2 provenant de l'unité globale 20.

L'unité locale 10 comporte en outre une résistance de lien R3 reliant la sortie du comparateur 12 du deuxième module de comparaison 101 à la grille du transistor à l'effet de champ Q1 du premier module de comparaison 100.

Ainsi, comme il sera décrit ultérieurement, le mode de fonctionnement du transistor Q1 dépend également de la sortie du comparateur 12 du deuxième module de comparaison 101.

La **figure 4** représente des circuits électroniques présents dans l'unité globale 20.

L'unité globale 20 génère en sortie un premier signal de consigne V1 représentant la première valeur de consigne et un deuxième signal de consigne V2 représentant la seconde valeur de consigne.

L'unité globale 20 comporte des moyens de génération 21 des signaux de consigne V1, V2 représentant respectivement les valeurs de consigne.

Dans le mode de réalisation décrit, les moyens de génération 21 comportent un module générateur de signal carré 210 et deux modules de génération de valeurs d'amplitude 211, 212.

Le module générateur de signal carré 210 coopère avec les modules de génération de valeurs d'amplitude 211, 212 afin de générer des signaux de consigne V1, V2.

Dans ce mode de réalisation, les signaux de consigne V1, V2 sont des signaux carrés d'amplitudes représentatifs des valeurs de consigne représentant respectivement des valeurs de consigne.

Ainsi les moyens de génération 21 génèrent un premier signal V1 représentant une première valeur de consigne A1 et un deuxième signal V2 représentant une seconde valeur de consigne A2.

L'unité globale 20 comporte des moyens de connexion (non visibles sur les figures) à un système de gestion de batteries 2000. Les valeurs de consigne A1, A2 sont reçues du système de gestion de batteries 2000.

L'unité globale 20 comporte en outre un module de comparaison 23 similaire aux premier et deuxième modules de comparaison 100, 101 de l'unité locale 10.

Dans ce module de comparaison 23, la deuxième entrée c2' du comparateur 12' est une valeur de référence au lieu d'être une division de la tension aux bornes du groupe des cellules de batterie.

Comme il sera décrit ultérieurement, le module de comparaison 23 est destiné à vérifier le signal de consigne V1 généré par les moyens de génération 21. Ce module de comparaison 23 est ainsi destiné aux opérations de test du dispositif d'interface 1000.

L'unité globale 20 comporte en outre un module électronique 24 étant dans le mode de réalisation décrit, un circuit oscillateur.

Le circuit oscillateur 24 comporte un condensateur d'oscillateur Co connecté entre l'entrée Eosc du circuit oscillateur 24 et sa référence de tension, étant ici de 0v.

Une sortie S1' du module de comparaison 23 est reliée à l'entrée Eosc du circuit oscillateur 24, un condensateur de sortie Cos reliant le module de comparaison 23 et le circuit oscillateur 24.

L'unité globale 20 comporte en outre un module de mesure 25, configuré pour mesurer la période et la fréquence du circuit oscillateur 24, comme il sera décrit ultérieurement.

Le module de mesure 25 est configuré en outre pour déterminer le nombre de groupes de cellules de batterie dont la tension est supérieure ou inférieure à une valeur de consigne là partir de cette période ou de cette fréquence.

Le module de mesure 25 est configuré pour adresser le nombre de cellules de batterie déterminé au système de gestion de batteries 2000.

Comme il sera décrit ci-dessus, en fonction du signal de sortie du comparateur 12 du premier module de comparaison 101 de l'unité locale 10, un condensateur de sortie Cso est connecté en parallèle avec le condensateur d'oscillateur Co.

On notera que la fréquence d'oscillation du circuit oscillateur 24 est modifiée lorsque le condensateur de sortie Cso est relié en parallèle au condensateur d'oscillateur Co.

Les circuits décrits ci-dessus en référence aux figures 3 et 4 sont destinés à surveiller la tension aux bornes des groupes de cellules, chaque groupe de cellules étant associé à une unité locale 10 afin de détecter des situations dans lesquelles au moins un groupe de cellules dépasse une certaine valeur (valeur de consigne) ou est inférieur, cette valeur étant établie par l'unité globale 20.

Comme indiqué ci-dessus, dans l'unité globale 20, les moyens de génération 21 génèrent un signal de consigne carré V1, l'amplitude A1 de ce signal carré étant fixée par un module de commande d'amplitude 211. L'amplitude A1 est reçue du système de gestion de batteries 2000 par l'unité globale 20.

Le signal de consigne carré V1 a une amplitude A1 représentative d'une première valeur de consigne.

Le signal carré V1 est relié à la troisième entrée E3 de chaque unité locale 10 de l'ensemble d'unités locales. Ce signal de consigne carré V1 a une amplitude crête correspondant à la première valeur de consigne A1

Le circuit de couplage formé par le condensateur de couplage $C_L$ par la résistance de couplage $R_L$ transforme le signal de consigne carré V1 dans un signal carré de sorte à le centrer par rapport à la valeur de référence 0Vcell du groupe de cellules de batterie. Ainsi, un signal de consigne modifié V01 est généré par rapport à la valeur de tension de référence du groupe de cellules de batterie.

Dans ce mode de réalisation, le module détecteur des crêtes 11 est un module détecteur de crêtes positives générant en sortie VC1 une tension équivalente à l'amplitude A1 représentative de la première valeur de consigne. La valeur de tension VC1 est fournie à la première entrée c1 du comparateur 12.

Le comparateur à hystérésis 12 génère en sortie un signal binaire VT1, l'état du signal VT1 étant fonction de la comparaison mise en oeuvre par le comparateur 12.

Si la valeur de la tension Vcell aux bornes du groupe des cellules de batterie 2 est supérieure à deux fois la valeur de l'amplitude A1, la sortie du comparateur VT1 est à l'état haut et le transistor à effet de champ Q1 est saturé.

Au contraire, lorsque la tension Vcell aux bornes du groupe de cellules de batterie 2 est inférieure à deux fois la valeur de l'amplitude A1, la sortie du comparateur VT1 est à l'état bas et le transistor à effet de champ Q1 est bloqué.

Lorsque le transistor Q1 d'une unité locale 10 est saturé, le condensateur de sortie $C_{SO}$, situé dans ce mode de réalisation à la sortie de l'unité locale 10, est relié en parallèle à la capacité d'oscillation Co disposée à l'entrée Eosc du circuit 24 oscillateur de l'unité globale 20.

Ainsi lorsqu'une unité locale 10 génère un signal de sortie Vs1 tel que le transistor Q1 est saturé, le condensateur de sortie Cso est relié en parallèle à la capacité d'oscillation Co, et la période de fonctionnement du circuit oscillateur 24 est proportionnelle à la valeur de la capacité de ce condensateur Co d'oscillation et peut être calculé par la formule $Tosc = K.(C_o+C_{SO})$, K étant une constante, et Co la capacité du condensateur d'oscillation, et Cso la capacité du condensateur de sortie Cso de l'unité locale 10.

Dans ce mode de réalisation, les capacités du condensateur de sortie et du condensateur d'oscillation sont identiques.

Le calcul de la période de fonctionnement Tosc est réalisé par le module de mesure 25.

Ainsi, lorsque les transistors Q1 d'un nombre N d'unités locales 10 sont saturés, N condensateurs de sortie Cso sont reliés en parallèle au condensateur d'oscillation $C_O$ du circuit oscillateur 24.

Ainsi, la période d'oscillation Tosc peut être calculée par la formule $Tosc=K.(N+1). Co$. Si le transistor Q1 est bloqué, le condensateur de sortie de l'unité locale 10 n'est pas relié en parallèle de la capacité d'oscillation Co du circuit oscillateur 24 de l'unité globale 20, la période d'oscillation Tosc du circuit oscillateur 24 n'étant pas modifiée et étant calculée par la formule Tosc = K. Co.

Dans ce mode de réalisation, le module de mesure 25 est configuré pour déduire, à partir de la valeur de période d'oscillation Tosc déterminée, le nombre N de groupes de cellules dont la tension est supérieure à deux fois l'amplitude A1 en utilisant la formule .

$$N = \frac{T}{K.Co} - 1$$

Les moyens de génération 21 de l'unité globale 20 comportent en outre un deuxième module de génération d'amplitude 212 destiné à coopérer avec le générateur de signal carré 210 afin de générer un second signal de consigne carré V2 d'amplitude A2 représentative de la seconde valeur de consigne.

Le signal de consigne carré V2 d'amplitude A2 est fourni au deuxième module de comparaison 101 de chaque unité locale 10 (figure 3).

Le signal de consigne carré V2 a une amplitude de crête correspondant à la seconde valeur de consigne A2.

Comme pour le premier module de comparaison 100, le condensateur de couplage $C_L$ et la résistance de couplage $R_L$ ramènent la valeur de l'amplitude A2 à une valeur prenant comme valeur de référence celle du groupe de cellules de batterie 2 (0Vcell). Le circuit de couplage génère un signal V02 fourni en entrée du détecteur de crête 11 qui génère à son tour une tension VC2 qui est fournie à une première entrée c1 du comparateur 12.

Le fonctionnement du deuxième module de comparaison 101 est similaire au fonctionnement du premier module de comparaison 100.

Ainsi, le comparateur 12 met en oeuvre la comparaison entre la tension VC2 générée en fonction du signal carré V2 d'amplitude représentative de la seconde valeur de consigne A2 avec la moitié de la tension entre les bornes du groupe de cellules de batterie (Vcell/2).

Ainsi, lorsque la tension aux bornes du groupe de cellule 2 est supérieure à deux fois l'amplitude A2 du signal V02, le transistor à effet de champ Q2 en sortie du comparateur 12 est saturé, reliant une résistance de charge Rd en parallèle du groupe de cellules.

On notera que la valeur de la résistance R en sortie du premier module de comparaison 100 est généralement différente de la valeur de la résistance de charge Rd du second module de comparaison 101. Ainsi, lorsqu'une opération d'équilibrage est mise en oeuvre et que la résistance de charge Rd est reliée au groupe de cellules de batterie 2, la valeur de la résistance de charge Rd est adaptée pour décharger le groupe de cellules de batterie 2 tandis que la valeur de la résistance R est adaptée au fonctionnement du circuit oscillateur 24.

Dans le mode de réalisation décrit, l'amplitude A2 représentative d'une seconde valeur de consigne est égale à la moitié d'une tension maximale Vmax à partir de laquelle une opération d'équilibrage doit être mise en oeuvre sur le groupe de cellules de batterie 2 (Vmax / 2 = A2).

Ainsi, pour tous les groupes de cellules 2 ayant une tension supérieure à ses bornes à deux fois la valeur de l'amplitude A2, c'est-à-dire supérieure à la tension maximale Vmax, les transistors à effet de champ Q2 sont saturés, la résistance charge Rd étant reliée en parallèle du groupe de cellules de batterie 2.

Autrement dit, lorsque le groupe de cellules de batterie 2 dépasse la tension maximale Vmax, une opération d'équilibrage est mise en oeuvre sur le groupe de cellules de batterie 2.

Chaque unité locale 10 est configurée en outre pour comparer un paramètre relatif à un groupe de cellules de batterie 2, tel que la tension aux bornes du groupe de cellules de batterie, à une seconde valeur de consigne, telle que la valeur maximale Vmax, et pour générer en fonction du résultat de la comparaison mise en oeuvre par les moyens de comparaison 12 une commande locale agissant sur l'unité locale 10.

Dans le mode de réalisation décrit, la commande locale est une commande d'équilibrage comportant un second signal de sortie VT2 représentatif du résultat de ladite comparaison, la résistance de charge Rd étant connectée ou pas à la sortie de l'unité locale en fonction du second signal de sortie VT2.

Dans le mode de réalisation décrit, le second signal de sortie représentatif du résultat de la comparaison VT2, en sortie du comparateur 12 du second module de comparaison 101, est un signal binaire pouvant présenter un niveau haut ou un niveau bas.

Dans le mode de réalisation décrit, le second signal de sortie VT2 présente un niveau haut lorsque la tension Vcell aux bornes du groupe de cellules de batterie 2 est supérieure à la tension maximale Vmax, et présente un niveau bas lorsque la tension Vcell aux bornes du groupe de cellules de batterie 2 est inférieure à la tension maximale Vmax.

Grâce à la structure du dispositif d'interface 1000, une opération d'équilibrage est mise en oeuvre sur la totalité des groupes de cellules de batterie 2 pour lesquels leur tension est supérieure à une valeur maximale Vmax (cette valeur maximale Vmax provenant de l'unité globale 20), sans pour autant devoir connaître ni la tension des différents groupes de cellules de batterie 2, ni identifier les groupes de cellules de batterie dépassant une tension maximale et nécessitant par conséquent de cette opération d'équilibrage.

L'unité locale 10 est en outre configurée pour générer le signal de sortie Vs1 en fonction du résultat de la comparaison du paramètre relatif à un groupe de cellules de batterie telle que la tension aux bornes du groupe de cellules de batterie 2, avec la seconde valeur de consigne A2.

Ainsi, le signal de commande VT11 du transistor Q1 est généré par le deuxième module de comparaison 101 au lieu d'être généré par le premier module de comparaison 100.

Pour cette opération, le moyen de génération 21 de l'unité globale 20 génère le signal de consigne carré V2 avec une amplitude A2 représentative de la première valeur de consigne, le signal de consigne V2 étant fourni au deuxième module de comparaison 101.

La période d'oscillation Tosc est mesurée par le module de mesure 25 dans l'unité globale 20, le nombre de groupes de cellules dépassant la première valeur de consigne étant déterminé en fonction de la période d'oscillation Tosc.

Le système de gestion de batteries 2000 recevant ce nombre de groupes de cellules, peut ainsi par comparaison de ce nombre obtenu, avec le nombre obtenu lorsque le premier module de comparaison 100 est utilisé pour cette même opération, vérifier que les premiers modules de comparaison 100 fonctionnent correctement.

On évite ainsi que la sécurité d'un module de batterie 1 soit remise en question par un mauvais fonctionnement d'un module de comparaison 100 dû par exemple à une panne d'un composant électronique.

L'opération mise en oeuvre par le deuxième module de comparaison 101 décrite ci-dessus représente une redondance de la mesure de la tension mise en oeuvre par le premier module de comparaison 100. Ainsi, le deuxième module de comparaison 101 est utilisé pour mettre en oeuvre des opérations d'équilibre et des mesures redondantes.

La génération du second signal carré V2 d'amplitude A2 représentative d'une première valeur de consigne par l'unité globale 20 est mise en oeuvre périodiquement de sorte à réaliser des opérations de test régulières du fonctionnement du premier module de comparaison 100.

On notera que lorsqu'on utilise le deuxième module de comparaison 101 comme circuit redondant pour mesurer la tension Vcell aux bornes du groupe de cellules de batterie, l'unité globale 20, en particulier les moyens de génération 21, génèrent le premier signal de consigne carré V1 à une valeur élevée de sorte que le comparateur 12 du premier module de comparaison 100 ne génère pas un signal en sortie VT1 au niveau haut.

Ainsi, le transistor Q1 est bloqué, laissant au deuxième module de comparaison 101 la possibilité de le mettre en mode de saturation. De manière similaire, en fonctionnement normal des unités locales 10, c'est-à-dire lorsque la tension est mesurée par le premier module de comparaison 100, le second signal de consigne carré V2 est généré à une valeur élevée de manière à ce que le comparateur 12 du deuxième module de comparaison 101 ne sature pas le transistor Q1.

On notera que la comparaison d'un nombre de cellules dépassant une valeur de tension, ou ne dépassant pas une valeur de tension, obtenue en utilisant le premier module de comparaison 100 et le premier signal de consigne carré V1, avec le nombre obtenu utilisant le deuxième module de comparaison 101 et le second signal de consigne carré V2, permet de détecter des anomalies dans l'un des modules de comparaison 100, 101.

Le module de comparaison 23 de l'unité globale 20 représente une unité de test configurée pour comparer une valeur de tension VC1' à l'entrée du comparateur 12' avec une valeur de référence Vref fournie à la deuxième entrée c2' du comparateur 12'. La valeur de tension VC1' fournie à la première entrée c1' du comparateur 12' est générée par le détecteur de crête 11' à partir d'un signal en entrée V01' du détecteur de crête 11'. Ce signal V01' est généré à partir du premier signal de consigne carré V1 généré par les moyens de génération 21. Comme pour les modules de comparaison 100, 101 décrits en référence à la figure 3, un condensateur de couplage $C_L$ et une résistance d'entrée $R_L$ transforment le signal de consigne carré V1 par rapport à une valeur de référence locale, étant ici de 0 volt.

Lors des opérations de test, la valeur V1 de l'amplitude A1 du signal de consigne est modifiée par rapport à la version Vref de façon à vérifier que le comparateur 12' génère un signal en sortie à des états différents.

Lorsque le signal en sortie du comparateur 12' est à un niveau haut, le transistor Qt est en saturation, un condensateur supplémentaire Cos est connecté en parallèle du condensateur d'oscillateur Co du circuit oscillateur 24.

Le module de mesure 25 mesure une période d'oscillation Tosc qui est fonction du résultat du comparateur 12' et le nombre de groupes dépassant la première valeur de consigne A1.

Ainsi, le bon fonctionnement du dispositif d'interface 1000 est assuré simplement et sans ajout de moyens complémentaires.

La **figure 5** représente des circuits électroniques dans une unité locale 10 destinés à la mesure de la température du groupe des cellules de batterie 2. Ainsi, le paramètre relatif à un groupe de cellules de batterie est la température du groupe des cellules de batterie 2.

Une unité locale 10 selon le mode de réalisation décrit comporte un premier module de comparaison de température 102 et un deuxième module de comparaison de température 103, ces modules de comparaison de température 102, 103 étant similaires respectivement aux modules de comparaison de tension 100, 101. Ainsi, uniquement les composants différents seront décrits ici.

Chaque module de comparaison de température 102, 103 comporte une sonde de température 14 disposée à proximité du groupe de cellules de batterie 2 et mesurant la température du groupe de cellules de batterie 2. La tension représentative de la température mesurée par la sonde de température 14 est fournie à la seconde entrée c2 du comparateur 12. Un signal WOC1 est fourni à la première entrée c1 du comparateur 12, ce signal WOC1 étant généré par un module détecteur de crête 11 qui a en entrée un signal de consigne carré W1 généré par l'unité globale 20, en particulier par un générateur de signal carré 210 (voir figure 6).

Dans le mode de réalisation décrit, le module générateur de signal carré 210, relatif à la température est différent du module générateur de signal carré 210 relatif à la tension.

Bien entendu, un seul générateur de signal carré pourrait être utilisé, dans d'autres modes de réalisation.

Le deuxième module de comparaison de température 103 constitue une unité de test afin de réaliser des mesures redondantes de manière similaire à celles décrites pour les mesures redondantes de la tension aux bornes du groupe de cellules de batterie réalisées par le deuxième module de comparaison 101. Dans le cas de la température, la sortie du comparateur 12 du second module de comparaison de température 103 est reliée au moyen d'une résistance R3 à la grille du transistor Q1 pouvant ainsi commander le transistor Q1 de sorte qu'il soit en mode saturé ou en mode bloqué.

La **figure 6** représente des circuits électroniques de l'unité globale 20 représentée concernant la mesure de température. La structure de ces circuits électroniques est identique à ceux représentés sur la figure 4.

L'unité globale 20 comporte un troisième module de génération d'amplitudes 211 coopérant avec le générateur de signal carré 210 pour générer le troisième signal de consigne carré W1.

L'unité globale 20 comporte en outre un quatrième module d'amplitudes 212 coopérant avec le générateur de signal carré 210 afin de générer un quatrième signal de consigne carré W2.

Les troisième et quatrième modules de génération d'amplitudes 211, 212 sont similaires aux premier et deuxième modules de génération, mais sont des entités distinctes dans ce mode de réalisation.

Le troisième signal de consigne carré W1 et quatrième signal de consigne carré W2 sont adressés aux unités locales de l'ensemble des unités locales 10 associé à l'unité globale 20.

L'unité globale 20 comporte en outre un module de comparaison additionnel similaire au module de comparaison 23 concernant la mesure de tension. Le module de comparaison additionnel est destiné à vérifier le signal de consigne W1 représentatif de la valeur de la température généré par les moyens de génération 21.

Le fonctionnement de l'ensemble de circuits électroniques concernant la température (figures 4 et 6) étant similaire au fonctionnement de l'ensemble de circuits concernant la tension ne sera pas décrit à nouveau.

Dans le mode de réalisation décrit, chaque unité locale 10 mesure la tension et la température des groupes de cellules de batterie 2.

Ainsi, chaque unité locale 10 comporte des moyens de comparaison pour comparer un paramètre (par exemple la tension) relatif à un groupe de cellules avec une valeur de consigne, et des moyens de comparaison pour comparer un paramètre supplémentaire (par exemple la température) relatif à un groupe de cellules avec une valeur de consigne supplémentaire.

Dans ce mode de réalisation, le paramètre relatif à un groupe de cellules est la tension Vcell aux bornes du groupe de cellules de batterie 2, et le paramètre supplémentaire correspond à la température du groupe de cellules de batterie 2.

Dans d'autres modes de réalisation, l'unité locale peut comporter soit des moyens de comparaison pour comparer la tension à une valeur de tension consigne, soit des moyens de comparaison pour comparer une température à une valeur de température de consigne.

Dans le mode de réalisation décrit, la totalité d'unités locales 10 du dispositif d'interface 1000 sont identiques.

Dans d'autres modes de réalisation, les unités locales dans un ensemble d'unités locales sont identiques entre elles, les unités locales d'ensembles différents étant différentes.

Selon encore un autre mode de réalisation, des unités locales d'un ensemble d'unités locales peuvent être différentes. Par exemple, un premier groupe d'unités locales comporte des cellules électroniques pour la mesure de la tension de la température et un deuxième groupe d'unités locales comporte seulement les circuits électroniques pour la mesure de la tension.

Selon un autre exemple, un premier groupe d'unités locales comporte des circuits de test et un deuxième groupe d'unités locales ne comportent pas de circuits de test.

Dans le mode de réalisation décrit, la totalité d'unités globales 20 sont identiques.

Dans d'autres modes de réalisation, les unités globales 20 sont différentes, par exemple certaines comportent, une unité de test et certaines ne comportent pas d'unité de test.

Revenant à la **figure 2,** le dispositif d'interface, comporte en outre un moyen de mesure du courant disposée en série de groupes de cellules de batterie.

Dans le mode de réalisation décrit, un « shunt » de mesure ou résistance de faible valeur 4 est disposé dans chaque colonne de cellules de batterie 3.

L'unité globale 20 comporte des moyens de mesure de la tension aux bornes du « shunt » de mesure 4. Ainsi, il est possible de connaître si le courant de charge et de décharge I dans la colonne de cellules 3, c'est-à-dire traversant les groupes de cellules de batterie 2, dépasse une valeur maximale.

Pour cela, l'unité globale 20 comporte des moyens de comparaison (non représentés) pour comparer la tension aux bornes des du « shunt » de mesure à une première valeur de tension de seuil représentative d'un courant de charge maximale ou seuil de charge, et à une deuxième valeur de tension de seuil représentative du courant de décharge maximale ou seuil de décharge.

Lorsque le courant de charge ou de décharge I dépasse respectivement le seuil de charge ou le seuil de décharge, l'unité globale 20 signale la présence d'une défaillance dans le groupe de cellules de batterie 2 de la colonne de cellules 3.

Le dispositif d'interface 1000 comporte en outre un dispositif d'annulation 5 d'une colonne 3. Un dispositif d'annulation 5 est connecté en série des groupes de cellules de batterie 2 de chaque colonne 3.

Ce dispositif d'annulation de colonnes 5 est destiné à déconnecter une colonne du reste des colonnes du module de batteries. Par exemple, ce dispositif d'annulation est un fusible.

Le dispositif d'annulation d'une colonne 5 est commandé par l'unité globale 2.

L'unité globale 20 comporte ainsi des moyens pour générer une commande A destinée à l'activation du dispositif d'annulation d'une colonne 5 lorsqu'une anomalie est détectée concernant le groupe de cellules de batterie de la colonne 3, telle qu'une tension d'un groupe de cellules 2 en dehors d'une plage autorisée, une température en dehors d'une plage autorisée ou un courant de charge ou de décharge trop élevé.

Grâce à la présence des dispositifs d'annulation d'une colonne 5 dans les colonnes du module de batterie 1, le module de batterie 1 ne nécessite pas de maintenance et reste disponible bien qu'il perde une partie de sa capacité.

On notera que le nombre de colonnes pouvant être annulé pendant la durée de vie estimée du module de batterie doit être pris en compte dans le dimensionnement du module de batterie afin d'assurer une capacité souhaitée minimale pendant la totalité de la vie du module de batteries.

Grâce à la structure du dispositif d'interface réalisant des opérations en local, la transmission d'un grand nombre de signaux à l'unité globale 20 est évitée, et le câblage d'un tel dispositif d'interface 1000 est ainsi simple et réduit. En outre, le bruit entre des lignes transportant des signaux entre les unités locales 10 et l'unité globale 20 est évité.

**Revendications**

**1.** Dispositif d'interface entre un système de gestion de batteries et des groupes de cellules de batterie comportant au moins un ensemble d'unités locales (10) et au moins une unité globale (20) reliée aux unités locales dudit au moins un ensemble et comportant des moyens de connexion à un système de gestion de batteries, chaque unité locale (10) dudit au moins un ensemble étant configurée pour être associée à un groupe de cellules de batterie (2),

- chaque unité locale (10) comportant un premier module de comparaison (100) configuré pour comparer un paramètre (Vcell, T$^a$) relatif à un groupe de cellules (2) associé avec une première valeur de consigne (A1, At1), ladite première valeur de consigne (A1, At1) provenant de ladite au moins une unité globale (20), et pour générer un signal de sortie (Vs1) représentatif du résultat de ladite comparaison, et

- ladite au moins une unité globale (20) étant configurée pour recevoir ladite première valeur de consigne (A1, At1), ledit dispositif d'interface (1000) étant **caractérisé en ce que** ladite au moins une unité globale (20) comporte un module électronique (24) ayant un paramètre de fonctionnement (Tosc) présentant une valeur globale qui est fonction des signaux de sortie (Vs1) provenant desdites unités locales (10) dudit au moins un ensemble, ladite valeur globale étant représentative du nombre de groupes de cellules dont lesdits résultats de comparaison indiquant que la valeur (Vcell, T$^a$) dudit paramètre relatif à un groupe de cellules (2) associé est supérieure à ladite première valeur de consigne (A1, At1), ou du nombre (N) de groupes de cellules dont lesdits résultats de comparaison indiquant que la valeur dudit paramètre (Vcell, T$^a$) relatif à un groupe de cellules (2) associé est inférieure à ladite première valeur de consigne (A1, At1) ;

- ledit module électronique (24) de l'unité globale (20) comportant un circuit oscillateur, ledit paramètre de fonctionnement étant la période d'oscillation (Tosc) dudit circuit oscillateur (24), chaque signal de sortie (Vs1) provenant desdites unités locales (10) dudit au moins un ensemble étant connecté audit circuit oscillateur au moyen d'un condensateur de sortie (Cso), de telle sorte que ledit condensateur de sortie (Cso) est connecté en parallèle avec un condensateur d'oscillateur (Co) dudit circuit oscillateur (24) ou déconnecté en fonction dudit signal de sortie (Vs1).

**2.** Dispositif d'interface conforme à la revendication 1, **caractérisé en ce que** l'unité globale (20) est configurée pour transmettre ladite valeur globale à un système de gestion de batteries.

**3.** Dispositif d'interface conforme à l'une des revendications 1 ou 2, **caractérisé en ce qu'**il comporte une unité de test (23) configurée pour comparer un signal de consigne représentatif d'une première valeur de consigne (A1) avec une valeur de référence (Vref).

**4.** Dispositif d'interface conforme à l'une des revendications 1 à 3, **caractérisé en ce que** chaque unité locale (10) comporte en outre un deuxième module de comparaison (101) pour comparer un paramètre relatif à un groupe de cellules de batterie (2) à une seconde valeur de consigne (A2, At2), ladite seconde valeur de consigne (A2, At2) provenant de ladite au moins une unité globale (20), et pour générer en fonction du résultat de ladite comparaison une commande locale agissant sur ladite unité locale (10).

5. Dispositif d'interface conforme à la revendication 4, **caractérisé en ce que** ladite commande locale comporte un second signal de sortie représentatif du résultat de ladite comparaison, une résistance de charge (Rd) étant connectée ou pas à la sortie de ladite unité locale (10) en fonction dudit second signal de sortie (VT2).

6. Dispositif d'interface conforme à l'une des revendications 4 ou 5, **caractérisé en ce qu'**il est configuré pour générer ledit premier signal de sortie (Vs1) en fonction du résultat de la comparaison dudit paramètre (Vcell, $T^a$) relatif à un groupe de cellules de batterie en outre avec ladite valeur de la seconde consigne (A2) généré par ledit deuxième module de comparaison (101).

7. Dispositif d'interface conforme à l'une des revendications 1 à 6, **caractérisé en ce que** ledit paramètre relatif à un groupe de cellules de batterie (2) est une tension ou une température et la première valeur de consigne (A1, At1) est une valeur de tension ou de température.

8. Dispositif d'interface conforme à l'une des revendications 1 à 7, **caractérisé en ce que** chaque unité locale est configurée en outre pour comparer au moins un paramètre supplémentaire (Vcell, $T^a$) relatif à un groupe de cellules (2) avec au moins une valeur de consigne supplémentaire (A1, At1).

9. Dispositif d'interface conforme à l'une des revendications 1 à 8, **caractérisé en ce que** chaque unité locale (10) comporte un premier module de comparaison (100) comportant des moyens de comparaison (12), le premier module de comparaison (100) ayant une première entrée (E1) recevant ledit paramètre (Vcell, $T^a$) relatif à un groupe de cellules de batterie et une seconde entrée (E3) recevant un signal de consigne (V1, W1) représentant ladite première valeur de consigne (A1, At1) et générant en sortie un signal de sortie (Vs1), et comportant des moyens de commutation (13) reliant ou pas le signal de sortie (Vs1) de la sortie de ladite unité locale (10) à ladite au moins une unité globale (20), lesdits moyens de commutation (13) étant commandés par ledit signal de sortie (Vs1).

10. Dispositif d'interface conforme à la revendication 9, **caractérisé en ce que** ladite au moins une unité globale (20) comporte des moyens de génération (21) dudit signal de consigne (V1, W1) représentant ladite première valeur de consigne (A1, At1), ledit signal étant un signal carré d'amplitude (V1, W1) représentative de ladite première valeur de consigne (A1, At1), chaque unité locale (10) étant connecté audit signal au moyen d'un condensateur de couplage ($C_L$).

11. Dispositif d'interface conforme à l'une des revendications 9 ou 10, prise en dépendance de la revendication 6, **caractérisé en ce que** chaque unité locale (10) comporte en outre un second module de comparaison (101) comportant des moyens de comparaison (12), ledit second module de comparaison (101) ayant une première entrée (E1) recevant ledit paramètre (Vcell, $T^a$) relatif à un groupe de cellules de batterie (2) et une seconde entrée (E3) recevant un second signal de consigne (V2, W2) représentant ladite valeur de la seconde consigne (A2, At2) et générant en sortie un signal de sortie (VT2), et comportant des moyens de commutation (13) reliant ou pas ladite résistance de charge (Rd) à la sortie de ladite unité locale (10), lesdits moyens de commutation (13) étant commandés par ledit signal de sortie (VT2).

12. Dispositif d'interface conforme à la revendication 11, **caractérisé en ce que** ladite au moins une unité globale (20) comporte en outre des moyens de génération (21) dudit signal de consigne (V2, W2) représentant ladite valeur de la seconde consigne (V2, W2), ledit signal étant un signal carré d'amplitude représentative de ladite valeur de la seconde consigne (A2, At2), chaque unité locale (10) étant connectée audit signal de consigne au moyen d'un condensateur de couplage ($C_L$).

13. Système de gestion de batteries comportant un dispositif d'interface conforme à l'une des revendications précédentes.

14. Module de batteries comportant au moins une colonne de cellules de batterie (3) comportant plusieurs groupes de cellules de batterie (2) connectés entre eux, chaque groupe de cellules de batterie (2) comportant plusieurs cellules de batterie (2a) connectées en parallèles entre elles, ledit module de batterie (1) étant **caractérisé en ce qu'**il comporte un dispositif d'interface conforme à l'une des revendications 1 à 12.

15. Ensemble comportant des groupes de cellules de batterie (2) et un système de gestion de batteries (2000), lesdits groupes de cellules de batterie (2) formant au moins une colonne de cellules (3), les groupes de cellules de batterie (2) étant connectés en série entre eux, chaque groupe de cellules de batterie (2) comportant plusieurs cellules de batterie (2a) connectées en parallèle entre elles, ledit ensemble étant **caractérisé en ce qu'**il comporte un dispositif d'interface (1000) conforme à l'une des revendications 1 à 12 disposé entre ledit système de gestion de batteries (2000) et lesdits groupes de cellules de batterie (2).

**Patentansprüche**

1. Vorrichtung zur Schnittstellenbildung zwischen einem Batterieverwaltungssystem und Batteriezellengruppen, aufweisend mindestens eine Gruppe lokaler Einheiten (10) und mindestens eine globale Einheit (20), die mit den lokalen Einheiten der mindestens einen Gruppe verbunden ist und Verbindungsmittel mit einem Batterieverwaltungssystem aufweist, wobei jede lokale Einheit (10) der mindestens einen Gruppe ausgelegt ist, um einer Batteriezellengruppe (2) zugeordnet zu sein,

   - wobei jede lokale Einheit (10) ein erstes Vergleichsmodul (100) aufweist, das ausgelegt ist, um einen Parameter (Vcell, T$^a$), der sich auf eine zugeordnete Zellengruppe (2) bezieht, mit einem ersten Sollwert (A1, At1) zu vergleichen, wobei der erste Sollwert (A1, At1) von der mindestens einen globalen Einheit (20) kommt, und um ein Ausgangssignal (Vs1) zu erzeugen, das für das Ergebnis des Vergleichs repräsentativ ist, und
   - wobei die mindestens eine globale Einheit (20) ausgelegt ist, um den ersten Sollwert (A1, At1) zu empfangen,

   wobei die Vorrichtung zur Schnittstellenbildung (1000) **dadurch gekennzeichnet ist, dass** die mindestens eine globale Einheit (20) ein elektronisches Modul (24) aufweist, das einen Betriebsparameter (Tosc) hat, der einen globalen Wert darstellt, der von den Ausgangssignalen (Vs1) abhängt, die von den lokalen Einheiten (10) der mindestens einen Gruppe kommen, wobei der globale Wert für die Anzahl von Zellgruppen repräsentativ ist, deren Vergleichsergebnisse angeben, dass der Wert (Vcell, T$^a$) des Parameters, der sich auf eine zugeordnete Zellengruppe (2) bezieht, größer als der erste Sollwert (A1, At1) ist, oder für die Anzahl (N) der Zellgruppen, deren Vergleichsergebnisse angeben, dass der Wert des Parameters (Vcell, T$^a$), der sich auf eine zugeordnete Zellengruppe (2) bezieht, kleiner als der erste Sollwert (A1, At1) ist;
   - wobei das elektronische Modul (24) der globalen Einheit (20) einen Schwingkreis aufweist, wobei der Betriebsparameter die Schwingperiode (Tosc) des Schwingkreises (24) ist, wobei jedes Ausgangssignal (Vs1) von den lokalen Einheiten (10) der mindestens einen Gruppe kommt, die mit dem Schwingkreis mittels eines Ausgangskondensators (Cso) derart verbunden ist, dass der Ausgangskondensator (Cso) mit einem Schwingungskondensator (Co) des Schwingkreises (24) parallel verbunden oder in Abhängigkeit von dem Ausgangssignal (Vs1) getrennt ist.

2. Vorrichtung zur Schnittstellenbildung nach Anspruch 1, **dadurch gekennzeichnet, dass** die globale Einheit (20) ausgelegt ist, um den globalen Wert an ein Batterieverwaltungssystem zu übertragen.

3. Vorrichtung zur Schnittstellenbildung nach einem der Ansprüche 1 oder 2, **dadurch gekennzeichnet, dass** sie eine Testeinheit (23) aufweist, die ausgelegt ist, um ein Sollsignal, das für einen ersten Sollwert (A1) repräsentativ ist, mit einem Referenzwert (Vref) zu vergleichen.

4. Vorrichtung zur Schnittstellenbildung nach einem der Ansprüche 1 bis 3, **dadurch gekennzeichnet, dass** jede lokale Einheit (10) ferner ein zweites Vergleichsmodul (101) aufweist, um einen Parameter, der sich auf eine Batteriezellengruppe (2) bezieht, mit einem zweiten Sollwert (A2, At2) zu vergleichen, wobei der zweite Sollwert (A2, At2) von der mindestens einen globalen Einheit (20) kommt, und um in Abhängigkeit vom Ergebnis des Vergleichs eine lokale Steuerung zu erzeugen, die auf die lokale Einheit (10) wirkt.

5. Vorrichtung zur Schnittstellenbildung nach Anspruch 4, **dadurch gekennzeichnet, dass** die lokale Steuerung ein zweites Ausgangssignal aufweist, das für das Ergebnis des Vergleichs repräsentativ ist, wobei ein Lastwiderstand (Rd) mit dem Ausgang der lokalen Einheit (10) in Abhängigkeit vom zweiten Ausgangssignal (VT2) verbunden ist oder nicht.

6. Vorrichtung zur Schnittstellenbildung nach einem der Ansprüche 4 oder 5, **dadurch gekennzeichnet, dass** sie ausgelegt ist, um das erste Ausgangssignal (Vs1) in Abhängigkeit vom Ergebnis des Vergleichs des Parameters (Vcell, T$^a$), der sich auf eine Batteriezellengruppe bezieht, ferner mit dem Wert des zweiten Sollwerts (A2) zu vergleichen, der vom zweiten Vergleichsmodul (101) erzeugt wird.

7. Vorrichtung zur Schnittstellenbildung nach einem der Ansprüche 1 bis 6, **dadurch gekennzeichnet, dass** der Parameter, der sich auf eine Batteriezellengruppe (2) bezieht, eine Spannung oder eine Temperatur ist und der erste Sollwert (A1, At1) ein Spannungs- oder Temperaturwert ist.

8. Vorrichtung zur Schnittstellenbildung nach einem der Ansprüche 1 bis 7, **dadurch gekennzeichnet, dass** jede lokale Einheit ferner ausgelegt ist, um mindestens einen zusätzlichen Parameter (Vcell, T$^a$),

der sich auf eine Zellengruppe (2) bezieht, mit mindestens einem zusätzlichen Sollwert (A1, At1) zu vergleichen.

9. Vorrichtung zur Schnittstellenbildung nach einem der Ansprüche 1 bis 8, **dadurch gekennzeichnet, dass** jede lokale Einheit (10) ein erstes Vergleichsmodul (100) aufweist, das Vergleichsmittel (12) aufweist, wobei das erste Vergleichsmodul (100) einen ersten Eingang (E1) hat, der den Parameter (Vcell, Tª) empfängt, der sich auf eine Batteriezellengruppe bezieht, und einen zweiten Eingang (E3), der ein Sollsignal (V1, W1) empfängt, das den ersten Sollwert (A1, At1) repräsentiert und am Ausgang ein Ausgangssignal (Vs1) erzeugt, und Umschaltmittel (13) aufweist, die das Ausgangssignal (Vs1) vom Ausgang der lokalen Einheit mit der mindestens einen globalen Einheit (20) verbinden oder nicht, wobei die Umschaltmittel (13) von dem Ausgangssignal (Vs1) gesteuert werden.

10. Vorrichtung zur Schnittstellenbildung nach Anspruch 9, **dadurch gekennzeichnet, dass** die mindestens eine globale Einheit (20) Mittel zum Erzeugen (21) des Sollsignals (V1, W1) aufweist, das den ersten Sollwert (A1, At1) darstellt, wobei das Signal ein Rechtecksignal der Amplitude (V1, W1) ist, die für den ersten Sollwert (A1, At1) repräsentativ ist, wobei jede lokale Einheit (10) mit dem Signal mittels eines Kopplungskondensators ($C_L$) verbunden ist.

11. Vorrichtung zur Schnittstellenbildung nach einem der Ansprüche 9 oder 10, herangezogen in Abhängigkeit von Anspruch 6, **dadurch gekennzeichnet, dass** jede lokale Einheit (10) ferner ein zweites Vergleichsmodul (101) aufweist, das Vergleichsmittel (12) aufweist, wobei das zweite Vergleichsmodul (101) einen ersten Eingang (E1) hat, der den Parameter (Vcell, Tª) empfängt, der sich auf eine Batteriezellengruppe (2) bezieht, und einen zweiten Eingang (E3), der ein zweites Sollsignal (V2, W2) empfängt, das den Wert des zweiten Sollwerts (A2, At2) darstellt und am Ausgang ein Ausgangssignal (VT2) erzeugt, und Umschaltmittel (13) aufweist, die den Lastwiderstand (Rd) mit dem Ausgang der lokalen Einheit (10) verbinden oder nicht, wobei die Umschaltmittel (13) vom Ausgangssignal (VT2) gesteuert werden.

12. Vorrichtung zur Schnittstellenbildung nach Anspruch 11, **dadurch gekennzeichnet, dass** die mindestens eine globale Einheit (20) ferner Mittel zum Erzeugen (21) des Sollsignals (V2, W2) aufweist, das den Wert des zweiten Sollwerts (V2, W2) darstellt, wobei das Signal ein Rechtecksignal der Amplitude ist, die für den Wert des zweiten Sollwerts (A2, At2) repräsentativ ist, wobei jede lokale Einheit (10) mit dem Sollsignal mittels eines Kopplungskondensators ($C_L$) verbunden ist.

13. Batterieverwaltungssystem, das eine Vorrichtung zur Schnittstellenbildung nach einem der vorangehenden Ansprüche aufweist.

14. Batteriemodul, das mindestens eine Batteriezellensäule (3) aufweist, die mehrere Gruppen miteinander verbundener Batteriezellen (2) aufweist, wobei jede Batteriezellengruppe (2) mehrere parallel miteinander verbundene Batteriezellen (2a) aufweist, wobei das Batteriemodul (1) **dadurch gekennzeichnet ist, dass** es eine Vorrichtung zur Schnittstellenbildung nach einem der Ansprüche 1 bis 12 aufweist.

15. Anordnung, die Batteriezellengruppen (2) und ein Batterieverwaltungssystem (2000) aufweist, wobei die Batteriezellengruppen (2) mindestens eine Zellensäule (3) bilden, wobei die Batteriezellengruppen (2) in Reihe miteinander verbunden sind, wobei jede Batteriezellengruppe (2) mehrere parallel miteinander verbundene Batteriezellen (2a) aufweist, wobei die Anordnung **dadurch gekennzeichnet ist, dass** sie eine Vorrichtung zur Schnittstellenbildung (1000) nach einem der Ansprüche 1 bis 12 aufweist, die zwischen dem Batterieverwaltungssystem (2000) und den Batteriezellengruppen (2) angeordnet ist.

**Claims**

1. Device for interfacing between a battery management system and groups of battery cells including at least one set of local units (10) and at least one global unit (20) connected to the local units of said at least one set and including means for connection to a battery management system, each local unit (10) of said at least one set being configured to be associated with a group of battery cells (2),

   - each local unit (10) including a first comparison module (100) configured to compare a parameter (Vcell, Tª) relative to an associated group of cells (2) to a first setting value (A1, At1), said first setting value (A1, At1) coming from said at least one global unit (20), and to generate an output signal (Vs1) representative of the result of said comparison, and
   - said at least one global unit (20) being configured to receive said first setting value (A1, At1), said interface device (1000) being **characterised in that** said at least one global unit (20) includes an electronic module (24) having an operating parameter (Tosc) having a global value that is a function of the output signals (Vs1) coming from said local units (10) of said at least one set, said global value being representative of the number of groups of cells of which said comparison results indicate that the value (Vcell, T$^a$) of said parameter relative to an associated group of cells (2) is greater than said first setting value (A1, At1), or of the number (N) of groups of cells of which said comparison results indicate that the value of said parameter (Vcell, T$^a$) relative to an associated group of cells (2) is less than said first setting value (A1, At1);
- said electronic module (24) of the global unit (20) including an oscillator circuit, said operating parameter being the period of oscillation (Tosc) of said oscillator circuit (24), each output signal (Vs1) coming from said local units (10) of said at least one set being connected to said oscillator circuit via an output capacitor (Cso), so that said output capacitor (Cso) is connected in parallel with an oscillator capacitor (Co) of said oscillator circuit (24) or disconnected according to said output signal (Vs1).

2. Interface device according to claim 1, **characterised in that** the global unit (20) is configured to transmit said global value to a battery management system.

3. Interface device according to one of claims 1 or 2, **characterised in that** it includes a test unit (23) configured to compare a setting signal representative of a first setting value (A1) to a reference value (Vref).

4. Interface device according to one of claims 1 to 3, **characterised in that** each local unit (10) further includes a second comparison module (101) for comparing a parameter relative to a group of battery cells (2) to a second setting value (A2, At2), said second setting value (A2, At2) coming from said at least one global unit (20), and to generate according to the result of said comparison a local command acting on said local unit (10).

5. Interface device according to claim 4, **characterised in that** said local command includes a second output signal representative of the result of said comparison, a load resistor (Rd) being connected or not to the output of said local unit (10) according to said second output signal (VT2).

6. Interface device according to one of claims 4 or 5, **characterised in that** it is configured to generate said first output signal (Vs1) according to the result of the comparison of said parameter (Vcell, T$^a$) relative to a group of battery cells also to said value of the second setting (A2) generated by said second comparison module (101).

7. Interface device according to one of claims 1 to 6, **characterised in that** said parameter relative to a group of battery cells (2) is a voltage or a temperature and the first setting value (A1, At1) is a voltage or temperature value.

8. Interface device according to one of claims 1 to 7, **characterised in that** each local unit is further configured to compare at least one additional parameter (Vcell, T$^a$) relative to a group of cells (2) to at least one additional setting value (A1, At1).

9. Interface device according to one of claims 1 to 8, **characterised in that** each local unit (10) includes a first comparison module (100) including comparison means (12), the first comparison module (100) having a first input (E1) receiving said parameter (Vcell, T$^a$) relative to a group of battery cells and a second input (E3) receiving a setting signal (V1, W1) representing said first setting value (A1, At1) and generating at the output an output signal (Vs1), and including switching means (13) connecting the output signal (Vs1) of the output of said local unit (10) to said at least one global unit (20) or not, said switching means (13) being controlled by said output signal (Vs1).

10. Interface device according to claim 9, **characterised in that** said at least one global unit (20) includes means (21) for generating said setting signal (V1, W1) representing said first setting value (A1, At1), said signal being an amplitude square wave (V1, W1) representative of said first setting value (A1, At1), each local unit (10) being connected to said signal via a coupling capacitor (C$_L$).

11. Interface device according to one of claims 9 or 10, when dependent on claim 6, **characterised in that** each local unit (10) further includes a second comparison module (101) including comparison means (12), said second comparison module (101) having a first input (E1) receiving said parameter (Vcell, T$^a$) relative to a group of battery cells (2) and a second input (E3) receiving a second setting signal (V2, W2) representing said value of the second setting (A2, At2) and generating at the output an output signal (VT2), and including switching means (13) connecting said load resistor (Rd) to the output of said local unit (10) or not, said switching means (13) being controlled by said output signal (VT2).

12. Interface device according to claim 11, **characterised in that** said at least one global unit (20) further includes means (21) for generating said setting signal (V2, W2) representing said value of the second setting (V2, W2), said signal being an amplitude square wave representative of said value of the second setting (A2, At2), each local unit (10) being connected to said setting signal via a coupling capacitor (C$_L$).

**13.** Battery management system including an interface device according to one of the preceding claims.

**14.** Battery module including at least one column of battery cells (3) including several groups of battery cells (2) connected to each other, each group of battery cells (2) including several battery cells (2a) connected in parallel to each other, said battery module (1) being **characterised in that** it includes an interface device according to one of claims 1 to 12.

**15.** Assembly including groups of battery cells (2) and a battery management system (2000), said groups of battery cells (2) forming at least one column of cells (3), the groups of battery cells (2) being connected in series to each other, each group of battery cells (2) including several battery cells (2a) connected in parallel to each other, said assembly being **characterised in that** it includes an interface device (1000) according to one of claims 1 to 12 disposed between said battery management system (2000) and said groups of battery cells (2).

Fig. 1

EP 3 526 619 B1

Fig. 2

EP 3 526 619 B1

Fig. 3

EP 3 526 619 B1

Fig. 4

Fig. 5

Fig. 6

EP 3 526 619 B1

## RÉFÉRENCES CITÉES DANS LA DESCRIPTION

**Documents brevets cités dans la description**

- EP 1977263 A
- EP 2485293 A1

- JP 2011247760 A